(19) Europäisches Patentamt
European Patent Office
Office européen des brevets

(11) **EP 3 920 418 A1**

(12) **EUROPEAN PATENT APPLICATION**

(43) Date of publication:
**08.12.2021 Bulletin 2021/49**

(51) Int Cl.:
**H03K 17/0812** $^{(2006.01)}$    **H03K 17/12** $^{(2006.01)}$
**H03K 17/16** $^{(2006.01)}$

(21) Application number: **21176688.6**

(22) Date of filing: **28.05.2021**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **01.06.2020   CN 202010486888**

(71) Applicant: **Murata Manufacturing Co., Ltd.**
**Nagaokakyo-shi, Kyoto 617-8555 (JP)**

(72) Inventor: **LIU, Chuipong**
**Hong Kong (CN)**

(74) Representative: **Laufhütte, Dieter et al**
**Lorenz Seidler Gossel**
**Rechtsanwälte Patentanwälte**
**Partnerschaft mbB**
**Widenmayerstraße 23**
**80538 München (DE)**

(54) **METHOD AND APPARATUS FOR AVOIDING PARASITIC OSCILLATION IN A PARALLEL SEMICONDUCTOR SWITCH**

(57)    The embodiments of the present disclosure provide a method and apparatus for avoiding parasitic oscillation in a parallel semiconductor switch. The method includes: allowing only one of the plurality of power components to control a turn-on transition of the switch and allowing only one of the plurality of power components to control a turn-off transition of the switch, by setting unbalanced driving impedances for the plurality of power components coupled in parallel. According to the embodiments of the present disclosure, parasitic oscillation in a switch transition may be avoided without impedance matching, and the switch transition may have a relatively small impact on switch characteristics.

Fig. 1

# Description

## TECHNICAL FIELD

The present disclosure relates to a parallel semiconductor switch, more specifically, to a method and apparatus for avoiding parasitic oscillation in a parallel semiconductor switch.

## BACKGROUND

A switching mode power supply is a high-frequency apparatus for electric energy conversion, which periodically turns on and turns off an electronic switching component by using a power semiconductor component (including but not limited to metal semiconductor field effect transistors MOSFET, bipolar transistor BJT or insulated gate bipolar transistor IGBT, etc.) in a control circuit. Pulse modulation is implemented on an input voltage by the power semiconductor component (hereinafter referred to as power component), so as to realize voltage conversion, adjustable output voltage and automatic voltage stabilization. Therefore, the switching mode power supply is also called a power converter.

In a field requiring large currents, power semiconductor components (such as MOSFET) provided as a switch in a power converter may operate in parallel (the switch is also called a parallel semiconductor switch, and a corresponding power supply is called a power supply operated by the parallel switch). This may reduce conduction loss, reduce a thermal resistance to a radiator by increasing surface area, and is scalable for high-power processing.

It is not uncommon that power supplies operated by parallel switches fail to operate. The problems seem to occur randomly. After replacing the semiconductor switch, the problems may sometimes be solved, but sometimes still exist in the converter unit. Generally, no overstress is observed in a power component during a steady-state operation. Detailed analysis shows that parasitic oscillation may occur in a switch transition period, depending on a combination of power components installed to operate in parallel. The parasitic oscillation may generate internal overstress, which is not easy to observe outside the component. When parasitic oscillation occurs, the internal overstress may destroy a relatively weak control terminal (such as a junction between a gate of the MOSFET and a source of the MOSFET), leading to problems.

In a switch transition period, switching current is redistributed among power components, triggering parasitic oscillation. Therefore, parasitic oscillation is prone to occur in parallel operations of power components. The redistribution of switching current is usually caused by a slight difference in turn-on moments between components or turn-off moments between components (due to different turn-on thresholds and turn-off thresholds and/or different driving impedances).

The components are turned on at different moments when operated in a linear region of a switch transient. The parasitic oscillation depends on parasitic parameters of the power components operated in parallel, such that potential problems may not be observed in a development stage. However, problems usually occur after the power components are in production. This leads to potential reliability problems in the parallel operation of power components.

According to an existing solution, all driving impedances of power components are matched, so that all power components coupled in parallel are turned on and turned off at a same moment. However, the solution is impractical in mass production.

According to another existing solution, the driving resistance is increased to suppress the parasitic oscillation, but this will increase switching loss and switching duration.

Therefore, a solution to avoid parasitic oscillation in a parallel semiconductor switch is needed.

## SUMMARY

Contrary to the idea of impedance matching in the existing technologies, the embodiments of the present disclosure proposes to introduce unbalanced driving impedances into a parallel semiconductor switch. In this way, only one of the plurality of power components coupled in parallel is turned on and only one of the plurality of power components coupled in parallel is turned off in a switch transition period. There is no redistribution of switch current when the components are operated in the linear region, thereby preventing parasitic oscillation between power components operated in parallel.

According to a first aspect of the present disclosure, there is provided a method for controlling a semiconductor switch, the semiconductor switch comprises a plurality of power components coupled in parallel. The method includes: allowing only one of the plurality of power components to control a turn-on transition of the switch and allowing only one of the plurality of power components to control a turn-off transition of the switch, by setting unbalanced driving impedances for the plurality of power components coupled in parallel.

According to a second aspect of the present disclosure, there is provided a semiconductor switch comprising a plurality of power components coupled in parallel. The plurality of power components coupled in parallel have unbalanced control-terminal driving impedances, allowing only one of the plurality of power components to control a turn-on transition of the switch and allowing only one of the plurality of power components to control a turn-off transition of the switch.

In some embodiments, the power component may be a metal semiconductor field effect transistor MOSFET. In some embodiments, the power component may be a bipolar transistor BJT. In some embodiments, the power component may be an insulated gate bipolar transistor IGBT.

In some embodiments, the allowing only one of the plurality of power components to control a turn-on transition of the switch and allowing only one of the plurality of power components to control a turn-off transition of the switch comprises one of:

> turning on the power component controlling the turn-on transition in response to turning on the switch, and turning on other power components after the power component controlling the turn-on transition is operated in a saturation region; and
> turning off the power component controlling the turn-off transition after other power components are operated in a cutoff region, in response to turning off the switch.

In some embodiments, when the turning on the power component controlling the turn-on transition in response to turning on the switch, and turning on other power components after the power component controlling the turn-off transition is operated in a saturation region is implemented by: setting a conduction driving impedance for the power component controlling the turn-on transition to be lower than a conduction driving impedance of other power components. A conduction driving impedance is a driving impedance of a control terminal of a power component in response to turning on the switch.

Optionally, the conduction driving impedances of the plurality of power components coupled in parallel satisfies:

$$\frac{R_{g\_other\_on}}{R_{g\_on}} > \frac{V_{drv} - V_{th\_min}}{V_{drv} - V_{th\_max}} \cdot \frac{C_{dg\_max}}{C_{dg\_min}},$$

wherein $R_{g\_on}$ is the conduction driving impedance of the power component controlling the turn-on transition of the switch, $R_{g\_other\_on}$ is the conduction driving impedance of other power components, $V_{drv}$ is a conduction driving voltage of a power component, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

In some embodiments, the turning off the power component controlling the turn-off transition after other power components are operated in a cutoff region, in response to turning off the switch is implemented by: setting a cutoff driving impedance for the power component controlling the turn-off transition to be greater than a cutoff driving impedance of other power components. A cutoff driving impedance is a driving impedance of a control terminal of a power component in response to turning off the switch.

Optionally, the cutoff driving impedance of the plurality of power components coupled in parallel satisfies:

$$\frac{R_{g\_off}}{R_{g\_other\_off}} > \frac{C_{dg\_max}}{C_{dg\_min}} \cdot \frac{V_{th\_max}}{V_{th\_min}},$$

wherein $R_{g\_off}$ is the cutoff driving impedance of the power component controlling the turn-off transition of the switch, $R_{g\_other\_off}$ is the cutoff driving impedance of other power components, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

In some embodiments, for the plurality of power components, at least a control terminal of the power component controlling the turn-on transition is coupled to a parallel driving circuit, and the parallel driving circuit comprises:

> a first branch, comprising a diode and a first impedance; and
> a second branch, comprising a diode and a second impedance.

In some embodiments, for the plurality of power components, at least a control terminal of the power component controlling the turn-off transition is coupled to a parallel driving circuit, and the parallel driving circuit comprises:

> a first branch, comprising a diode and a third impedance; and
> a second branch, comprising a diode and a fourth impedance.

In some embodiments, the power component controlling the turn-on transition of the switch is different from the power component controlling the turn-off transition of the switch.

In other embodiments, the power component controlling the turn-on transition of the switch may be same as the power component controlling the turn-off transition of the switch.

According to the embodiments of the present disclosure, parasitic oscillation in a switch transition may be avoided without impedance matching, and the switch transition may have a relatively small impact on switch characteristics (such as switch loss and switch speed).

**BRIEF DESCRIPTION OF THE ACCOMPANYING DRAWINGS**

The above and additional features of the present disclosure will become more obvious from the following description in conjunction with the accompanying drawings, in which:

Fig. 1 schematically shows a diagram of a parallel semiconductor switch according to an embodiment of the present disclosure.
Fig. 2 schematically shows a diagram of a parallel semiconductor switch according to another embodiment of the present disclosure.

In the drawings, same reference signs indicate same or similar elements.

## DETAILED DESCRIPTION

The solution of the present disclosure will be described in details below in conjunction with the drawings and specific embodiments. It should be noted that the present disclosure should not be limited to the specific embodiments described below. In addition, for brevity, detailed descriptions of well-known technologies that are not directly related to the present disclosure are omitted to prevent confusion in the understanding of the present disclosure.

In order to avoid parasitic oscillation in a parallel semiconductor switch, the embodiments of the present disclosure propose to ensure that only one of a plurality of power components operated in parallel is turned on and only one of the plurality of power components operated in parallel is turned off in a switch transition period of a parallel semiconductor switch. That is, only one power component controls a turn-on transition of the switch, and only one power component controls a turn-off transition of the switch.

The power component controlling the turn-on transition of the switch may be same as the power component controlling the turn-off transition of the switch. The power component controlling the turn-on transition of the switch may be different from the power component controlling the turn-off transition of the switch. Switching loss may be centralized on selected components for controlling the turn-on transition and the turn-off transition. Therefore, in most cases, it is optional but not limited to select different components to control the turn-on transition and turn-off transition respectively, so that heat generated by switching loss may be shared.

In the following embodiments, MOSFETs is mainly used as an example of a power semiconductor component for description. However, it should be understood that the embodiments of the present disclosure are also applicable to switches including other types of power semiconductor components coupled in parallel, such as insulated gate bipolar transistors IGBT or bipolar transistor BJT, etc.

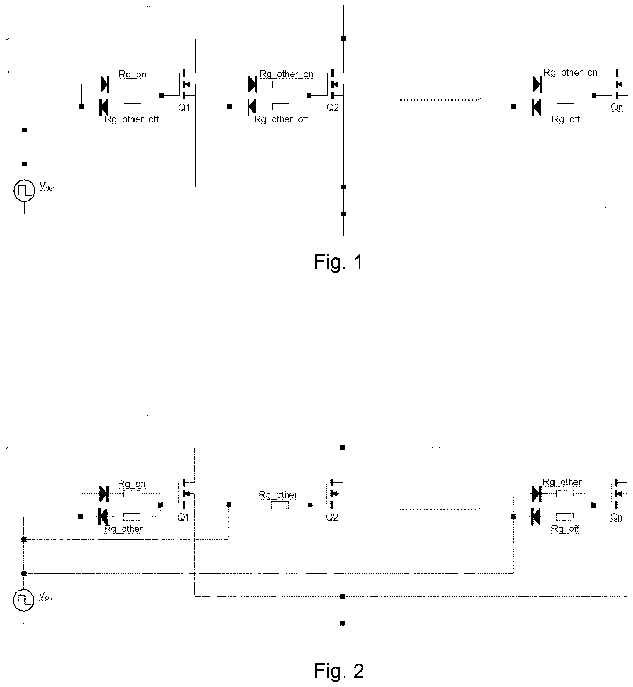

Fig. 1 schematically shows a diagram of a parallel semiconductor switch according to an embodiment of the present disclosure.

As shown in Fig.1, the parallel semiconductor switch includes a plurality of power components Q1, Q2...Qn. It should be understood that although only three power components are shown in Fig. 1, the parallel semiconductor switch may include more or less (such as two) power components. The present disclosure is not limited to the number of power components shown in Fig. 1. In addition, the power component is shown as a MOSFET in Fig. 1. While in other embodiments, the power component may further be other power semiconductor components, such as a bipolar transistor BJT.

In the example of Fig. 1, power components controlling the turn-on and turn-off transitions is selected by using unbalanced (i.e., different) driving impedances. Specifically, in the example, Q1 is selected as the power component controlling the turn-on transition, and Qn is selected as the power component controlling the turn-off transition.

For brevity of design and description, a driving circuit for each power component Qi (i=1, 2...) includes two branches. Diodes are configured to allow the two branches to work during a turn-on period of the switch and a turn-off period of the switch respectively. Due to the configuration of the diodes in the driving circuit shown in Fig. 1, $R_{g\_on}$ is a conduction driving impedance of the selected power component Q1 controlling the turn-on transition, and $R_{g\_other\_on}$ is a conduction driving impedance of all other power components coupled in parallel. In the present disclosure, a conduction driving impedance is a driving impedance of a control terminal of a power component when turning on the switch, such as a driving impedance of a gate of a MOSFET Qi (i=1, 2...) when turning on the switch shown in Fig. 1.

$R_{g\_off}$ is a cutoff driving impedance of the selected power component Qn controlling the turn-off transition, and $R_{g\_other\_off}$ is a cutoff driving impedance of all other power components coupled in parallel. In the present disclosure, a cutoff driving impedance is a driving impedance of a control terminal of a power component when turning off the switch, such as a driving impedance of a gate of a MOSFET Qi (i=1, 2...) when turning off the switch shown in Fig. 1.

In this example, to ensure that the component Q1 selected to control the turn-on transition is an only component conductive in a turn-on transition of the switch, the conduction driving impedance of the component may be determined according to Miller effect equation. A basic idea based on Miller effect is that, all other power components Qj (j≠1) coupled in parallel are maintained cutoff when the selected power component Q1 is in the turn-on transition, according to a falling slope of a voltage VDS between a drain of Q1 and a source of Q1. The following formula (1) may be achieved.

$$\frac{R_{g\_other\_on}}{R_{g\_on}} > \frac{V_{drv} - V_{th\_min}}{V_{drv} - V_{th\_max}} \cdot \frac{C_{dg\_max}}{C_{dg\_min}} \quad (1)$$

Wherein $R_{g\_on}$ is the conduction driving impedance of the power component controlling the turn-on transition of the switch (i.e., Q1 in this example), $R_{g\_other\_on}$ is the conduction driving impedance of other power components, $V_{drv}$ is a conduction driving voltage of a power component, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

If the conduction driving impedances satisfies formula (1), only the selected power component Q1 may participate in the turn-on transition of the switch, and all other power components coupled in parallel may only be turned on as a zero voltage switch (ZVS) after the turn-on transition.

It should be understood that the conduction driving impedances $R_{g\_other\_on}$ of other power components shown in Fig. 1 may have a same value or may have different values. As long as each of the conduction driving impedances $R_{g\_other\_on}$ of other power components satisfies the formula (1), it may be ensured that the selected component Q1 for controlling the turn-on transition is the only component conductive in the turn-on transition.

In this example, to ensure that the component Qn selected to control the turn-off transition is an only component to be turned off in a turn-off transition of the switch, the component Qn should be a component having a largest cutoff driving impedance $R_{g\_off}$ and should be turned off lastly. This means that all other components coupled in parallel have relatively low cutoff driving impedances and may be turned off as a ZVS before Qn starts to be turned off. In addition, in order to avoid the other components being conductive in the turn-off transition of the selected component Qn, the cutoff driving impedance may be determined according to Miller effect equation. A basic idea based on Miller effect is that, all other power components Qj (j#n) coupled in parallel are maintained cutoff when the selected power component Qn is in the turn-off transition, according to a rising slope of a voltage VDS of Qn. The following formula (2) may be achieved.

$$\frac{R_{g\_off}}{R_{g\_other\_off}} > \frac{C_{dg\_max}}{C_{dg\_min}} \cdot \frac{V_{th\_max}}{V_{th\_min}} \quad (2)$$

Wherein $R_{g\_off}$ is the cutoff driving impedance of the power component controlling the turn-off transition of the switch (i.e., Qn in this example), $R_{g\_other\_off}$ is the cutoff driving impedance of other power components, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

If the conduction driving impedances satisfies formula (2), only the selected power component Qn may participate in the turn-off transition of the switch, and all other power components coupled in parallel may already be turned off as a ZVS before the turn-off transition.

It should be understood that the cutoff driving impedances $R_{g\_other\_off}$ of other power components shown in Fig. 1 may have a same value or may have different values. As long as each of the cutoff driving impedances $R_{g\_other\_off}$ of other power components satisfies the formula (2), it may be ensured that the selected component Qn for controlling the turn-off transition is the only component to be turned off in the turn-off transition.

According to the embodiments of the present disclosure, the parasitic oscillation caused by the parallel operation of power components may be avoided. In addition, for parallel operation, there is no need to sacrifice the switch characteristics (for example, not significantly affecting switch loss and switch speed). A desired conduction characteristic may only be determined by $R_{g\_on}$ and $R_{g\_other\_on}$ according to formula (1). While a desired cutoff characteristic may only be determined by $R_{g\_off}$ and $R_{g\_other\_off}$ according to formula (2).

It should be understood that the structure in Fig. 1 is only an example. The driving circuit of the power components coupled in parallel is not limited to the configuration using diodes and resistors as shown in Fig. 1, but may be any configuration that may provide driving impedances satisfying formulas (1) and (2).

For example, in the example of Fig. 1, the conduction driving impedance and the cutoff driving impedance are designed and described separately by setting diodes for convenience. However, in practice, $R_{g\_other\_on}$ and $R_{g\_other\_off}$ may not be designed separately, but combined as a same impedance, as shown in Fig. 2.

Fig. 2 schematically shows a diagram of a parallel semiconductor switch according to another embodiment of the present disclosure.

Similar to Fig. 1, Q1 is selected as a power component controlling the turn-on transition, and Qn is selected as a power component controlling the turn-off transition. The driving circuits of the control terminals of Q1 and Qn still include two branches. Diodes are configured to allow the two branches to work during a turn-on period of the switch and a turn-off period of the switch respectively. A difference from the circuit in Fig. 1 is that the driving circuit of the power component not selected to control the turn-on transition and the turn-off transition is simplified, and no longer has two branches. The driving impedances $R_{g\_other\_on}$ drand $R_{g\_other\_off}$ are combined as a same impedance $R_{g\_other}$.

$R_{g\_other\_on}$ and $R_{g\_other\_off}$ in formulas (1) and (2) are replaced by $R_{g\_other}$. The following formulas (3) and (4) may be obtained.

$$\frac{R_{g\_other}}{R_{g\_on}} > \frac{V_{drv} - V_{th\_min}}{V_{drv} - V_{th\_max}} \square \frac{C_{dg\_max}}{C_{dg\_min}} \quad (3)$$

$$\frac{R_{g\_off}}{R_{g\_other}} > \frac{C_{dg\_max}}{C_{dg\_min}} \square \frac{V_{th\_max}}{V_{th\_min}} \quad (4)$$

Wherein $R_{g\_on}$ is a conduction driving impedance of the power component controlling the turn-on transition of the switch (i.e., Q1 in this example), $R_{g\_off}$ is a cutoff driving impedance of the power component controlling the turn-off transition of the switch (i.e., Qn in this example), $R_{g\_other}$ is a driving impedance of other power components, $V_{drv}$ is a conduction driving voltage of a power component, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

If the conduction driving impedances satisfies formulas (3) and (4), only the selected power component Q1 may participate in the turn-on transition of the switch, and all other power components coupled in parallel may only be turned on as a zero voltage switch (ZVS) after the turn-on transition; and only the selected power component Qn may participate in the turn-off transition of the switch, and all other power components coupled in parallel may already be turned off as a ZVS before the turn-off transition.

In the above embodiments, MOSFET is used as an example of a power semiconductor component. However, it should be understood that the embodiments of the present disclosure are also applicable to switches including other types of power semiconductor components coupled in parallel, such as insulated gate bipolar transistors IGBT or Bipolar transistors, etc. In case that other power semiconductor components coupled in parallel are used as the switch, the driving circuit may change accordingly with the type of the power components. However, this still follows the basic idea of the present disclosure. That is, only one of the plurality of power components is allowed to control a turn-on transition of the switch and only one of the plurality of power components is allowed to control a turn-off transition of the switch, by setting unbalanced driving impedances for the plurality of power components coupled in parallel.

According to another aspect of the present disclosure, a corresponding method for controlling a semiconductor switch is further provided. The method includes allowing only one of the plurality of power components to control a turn-on transition of the switch and allowing only one of the plurality of power components to control a turn-off transition of the switch, by setting unbalanced driving impedances for the plurality of power components coupled in parallel.

In some embodiments, the power component may be a metal semiconductor field effect transistor MOSFET. In some embodiments, the power component may be a bipolar transistor BJT. In some embodiments, the power component may be an insulated gate bipolar transistor IGBT.

In some embodiments, the allowing only one of the plurality of power components to control a turn-on transition of the switch and allowing only one of the plurality of power components to control a turn-off transition of the switch comprises one of: turning on the power component controlling the turn-on transition in response to turning on the switch, and turning on other power components after the power component controlling the turn-on transition is operated in a saturation region; and turning off the power component controlling the turn-off transition after other power components are operated in a cutoff region, in response to turning off the switch.

In some embodiments, when the turning on the power component controlling the turn-on transition in response to turning on the switch, and turning on other power components after the power component controlling the turn-off transition is operated in a saturation region is implemented by: setting a conduction driving impedance for the power component controlling the turn-on transition to be lower than a conduction driving impedance of other power components. A conduction driving impedance is a driving impedance of a control terminal of a power component in response to turning on the switch.

Optionally, the conduction driving impedances of the plurality of power components coupled in parallel satisfies:

$$\frac{R_{g\_other\_on}}{R_{g\_on}} > \frac{V_{drv} - V_{th\_min}}{V_{drv} - V_{th\_max}} \cdot \frac{C_{dg\_max}}{C_{dg\_min}} \quad ,$$

wherein $R_{g\_on}$ is the conduction driving impedance of the power component controlling the turn-on transition of the switch, $R_{g\_other\_on}$ is the conduction driving impedance of other power components, $V_{drv}$ is a conduction driving voltage of a power component, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

In some embodiments, the turning off the power component controlling the turn-off transition after other power components are operated in a cutoff region, in response to turning off the switch is implemented by: setting a cutoff driving impedance for the power component controlling the turn-off transition to be greater than a cutoff driving impedance of other power components. A cutoff driving impedance is a driving impedance of a control terminal of a power component in response to turning off the switch.

Optionally, the cutoff driving impedance of the plurality of power components coupled in parallel satisfies:

$$\frac{R_{g\_off}}{R_{g\_other\_off}} > \frac{C_{dg\_max}}{C_{dg\_min}} \cdot \frac{V_{th\_max}}{V_{th\_min}},$$

wherein $R_{g\_off}$ is the cutoff driving impedance of the power component controlling the turn-off transition of the switch, $R_{g\_other\_off}$ is the cutoff driving impedance of other power components, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

In some embodiments, for the plurality of power components, at least a control terminal of the power component controlling the turn-on transition is coupled to a parallel driving circuit, and the parallel driving circuit comprises: a first branch, comprising a diode and a first impedance; and a second branch, comprising a diode and a second impedance.

In some embodiments, for the plurality of power components, at least a control terminal of the power component controlling the turn-off transition is coupled to a parallel driving circuit, and the parallel driving circuit comprises: a first branch, comprising a diode and a third impedance; and a second branch, comprising a diode and a fourth impedance.

In some embodiments, the power component controlling the turn-on transition of the switch is different from the power component controlling the turn-off transition of the switch.

In other embodiments, the power component controlling the turn-on transition of the switch may be same as the power component controlling the turn-off transition of the switch.

According to the method of the embodiments of the present disclosure, parasitic oscillation in a switch transition may be avoided. Specific details may be referred according to the description of the circuit shown in Fig. 1 and Fig. 2, which will not be repeated here.

It should be noted that in the above description, the technical solutions of the present disclosure are shown by way of example only, but it does not mean that the present disclosure is limited to the above operations and circuit structures. The operations and circuit structures may be adjusted and selected as needed. Therefore, some operations and units are not necessary elements for implementing the overall inventive idea of the present disclosure. Thus, the necessary technical features of the present disclosure are only limited to the minimum requirements that may realize the overall inventive idea of the present disclosure, and are not limited by the above specific examples.

According to the embodiments of the present disclosure, parasitic oscillation in a switch transition may be avoided without impedance matching, and the switch transition may have a relatively small impact on switch characteristics (such as switch loss and switch speed).

So far, the present disclosure has been described in conjunction with optional embodiments. It should be understood that those skilled in the art may make various changes, substitutions and additions without departing from the spirit and scope of the present disclosure. Therefore, the scope of the present disclosure is not limited to the above specific embodiments, but should be defined by the appended claims.

## Claims

1. A method for controlling a semiconductor switch, the semiconductor switch comprises a plurality of power components coupled in parallel, and the method comprises:
   allowing only one of the plurality of power components to control a turn-on transition of the switch and allowing only one of the plurality of power components to control a turn-off transition of the switch, by setting unbalanced driving impedances for the plurality of power components coupled in parallel.

2. The method of claim 1, wherein the allowing only one of the plurality of power components to control a turn-on transition of the switch and allowing only one of the plurality of power components to control a turn-off transition of the switch comprises one of:

   turning on the power component controlling the turn-on transition in response to turning on the switch, and turning on other power components after the power component controlling the turn-on transition is operated in a saturation region; and
   turning off the power component controlling the turn-off transition after other power components are operated in a cutoff region, in response to turning off the switch.

3. The method of claim 2, wherein the turning on the power component controlling the turn-on transition in response to turning on the switch, and turning on other power components after the power component controlling the turn-off transition is operated in a saturation region is implemented by:
   setting a conduction driving impedance for the power component controlling the turn-on transition to be lower than a conduction driving impedance of other power components, wherein a conduction driving impedance is a driving impedance of a control terminal of a power component in response to turning on the switch.

4. The method of claim 3, wherein the conduction driving impedances of the plurality of power components coupled in parallel satisfies:

$$\frac{R_{g\_other\_on}}{R_{g\_on}} > \frac{V_{drv} - V_{th\_min}}{V_{drv} - V_{th\_max}} \cdot \frac{C_{dg\_max}}{C_{dg\_min}},$$

wherein $R_{g\_on}$ is the conduction driving impedance of the power component controlling the turn-on transition of the switch, $R_{g\_other\_on}$ is the conduction driving impedance of other power components, $V_{drv}$ is a conduction driving voltage of a power component, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

5. The method of claim 2, wherein the turning off the power component controlling the turn-off transition after other power components are operated in a cutoff region, in response to turning off the switch is implemented by:
setting a cutoff driving impedance for the power component controlling the turn-off transition to be greater than a cutoff driving impedance of other power components, wherein a cutoff driving impedance is a driving impedance of a control terminal of a power component in response to turning off the switch.

6. The method of claim 5, wherein the cutoff driving impedance of the plurality of power components coupled in parallel satisfies:

$$\frac{R_{g\_off}}{R_{g\_other\_off}} > \frac{C_{dg\_max}}{C_{dg\_min}} \cdot \frac{V_{th\_max}}{V_{th\_min}},$$

wherein $R_{g\_off}$ is the cutoff driving impedance of the power component controlling the turn-off transition of the switch, $R_{g\_other\_off}$ is the cutoff driving impedance of other power components, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

7. The method of claim 1, wherein for the plurality of power components, at least a control terminal of the power component controlling the turn-on transition is coupled to a parallel driving circuit, and the parallel driving circuit comprises:

    a first branch, comprising a diode and a first impedance; and
    a second branch, comprising a diode and a second impedance.

8. The method of claim 1, wherein for the plurality of power components, at least a control terminal of the power component controlling the turn-off transition is coupled to a parallel driving circuit, and the parallel driving circuit comprises:

    a first branch, comprising a diode and a third impedance; and
    a second branch, comprising a diode and a fourth impedance.

9. A semiconductor switch, comprising a plurality of power components coupled in parallel, wherein:
the plurality of power components coupled in parallel have unbalanced control-terminal driving impedances, allowing only one of the plurality of power components to control a turn-on transition of the switch and allowing only one of the plurality of power components to control a turn-off transition of the switch.

10. The switch of claim 9, wherein the power component comprises a metal semiconductor field effect transistor MOSFET, a bipolar transistor BJT, or an insulated gate bipolar transistor IGBT.

11. The switch of claim 9, wherein a conduction driving impedance for the power component controlling the turn-on transition is lower than a conduction driving impedance of other power components, wherein a conduction driving impedance is a driving impedance of a control terminal of a power component in response to turning on the switch.

12. The switch of claim 11, wherein the conduction driving impedances of the plurality of power components coupled in parallel satisfies:

$$\frac{R_{g\_other\_on}}{R_{g\_on}} > \frac{V_{drv} - V_{th\_min}}{V_{drv} - V_{th\_max}} \cdot \frac{C_{dg\_max}}{C_{dg\_min}},$$

wherein $R_{g\_on}$ is the conduction driving impedance of the power component controlling the turn-on transition of the switch, $R_{g\_other\_on}$ is the conduction driving impedance of other power components, $V_{drv}$ is a conduction driving voltage of a power component, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

13. The switch of claim 9, wherein a cutoff driving impedance for the power component controlling the turn-off transition is greater than a cutoff driving impedance of other power components, wherein a cutoff driving impedance is a driving impedance of a control terminal of a power component in response to turning off the switch.

14. The switch of claim 13, wherein the cutoff driving impedance of the plurality of power components coupled in parallel satisfies:

$$\frac{R_{g\_off}}{R_{g\_other\_off}} > \frac{C_{dg\_max}}{C_{dg\_min}} \cdot \frac{V_{th\_max}}{V_{th\_min}},$$

wherein $R_{g\_off}$ is the cutoff driving impedance of the power component controlling the turn-off transition of the switch, $R_{g\_other\_off}$ is the cutoff driving impedance of other power components, $V_{th\_min}$ is a minimum conduction threshold of a power component, $V_{th\_max}$ is a maximum conduction threshold of a power component, $C_{dg\_min}$ is a minimum reverse transfer capacitance of a power component and $C_{dg\_max}$ is a maximum reverse transfer capacitance of a power component.

15. The switch of claim 9, wherein for the plurality of power components, at least a control terminal of the power component controlling the turn-on transition is coupled to a parallel driving circuit, and the parallel driving circuit comprises:

a first branch, comprising a diode and a first impedance; and
a second branch, comprising a diode and a second impedance;
or

wherein for the plurality of power components, at least a control terminal of the power component controlling the turn-off transition is coupled to a parallel driving circuit, and the parallel driving circuit comprises:

a first branch, comprising a diode and a third impedance; and
a second branch, comprising a diode and a fourth impedance.

Fig. 1

Fig. 2

Europäisches
Patentamt

European
Patent Office

Office européen
des brevets

**EUROPEAN SEARCH REPORT**

Application Number

EP 21 17 6688

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 735 771 B1 (LU JUNCHENG [US] ET AL) 15 August 2017 (2017-08-15) * figures 2, 3 * | 1-15 | INV. H03K17/0812 H03K17/12 H03K17/16 |
| X | US 2017/019097 A1 (SATO TADAHIKO [JP]) 19 January 2017 (2017-01-19) * figures 1, 2 * | 1-15 | |
| X | US 2017/033790 A1 (OSANAI YOSUKE [JP]) 2 February 2017 (2017-02-02) * figures 1, 2, 3 * | 1-15 | |
| A | EP 3 107 197 A1 (MITSUBISHI ELECTRIC R&D CT EUROPE BV [NL] ET AL.) 21 December 2016 (2016-12-21) * the whole document * | 1-15 | |
| A | US 2015/028383 A1 (VOSS STEPHAN [DE] ET AL) 29 January 2015 (2015-01-29) * figures 2, 3 * | 7,8,15 | |
| A | US 9 484 908 B1 (LU JUNCHENG [US] ET AL) 1 November 2016 (2016-11-01) * figure 1A * | 1-15 | |

TECHNICAL FIELDS SEARCHED (IPC)

H03K

The present search report has been drawn up for all claims

| Place of search | Date of completion of the search | Examiner |
|---|---|---|
| The Hague | 23 September 2021 | Loiseau, Ludovic |

EPO FORM 1503 03.82 (P04C01)

**ANNEX TO THE EUROPEAN SEARCH REPORT
ON EUROPEAN PATENT APPLICATION NO.**

EP 21 17 6688

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2021

| Patent document cited in search report | | Publication date | Patent family member(s) | | Publication date |
|---|---|---|---|---|---|
| US 9735771 | B1 | 15-08-2017 | CN | 109643994 A | 16-04-2019 |
| | | | CN | 109690951 A | 26-04-2019 |
| | | | DE | 112017003627 T5 | 11-04-2019 |
| | | | DE | 112017003652 T5 | 04-04-2019 |
| | | | US | 9735771 B1 | 15-08-2017 |
| | | | US | 9748949 B1 | 29-08-2017 |
| | | | US | 2018026628 A1 | 25-01-2018 |
| | | | WO | 2018015921 A2 | 25-01-2018 |
| | | | WO | 2018015924 A2 | 25-01-2018 |
| US 2017019097 | A1 | 19-01-2017 | CN | 106357251 A | 25-01-2017 |
| | | | JP | 6528575 B2 | 12-06-2019 |
| | | | JP | 2017028779 A | 02-02-2017 |
| | | | US | 2017019097 A1 | 19-01-2017 |
| US 2017033790 | A1 | 02-02-2017 | JP | 6252561 B2 | 27-12-2017 |
| | | | JP | 2017028956 A | 02-02-2017 |
| | | | US | 2017033790 A1 | 02-02-2017 |
| EP 3107197 | A1 | 21-12-2016 | CN | 107735950 A | 23-02-2018 |
| | | | EP | 3107197 A1 | 21-12-2016 |
| | | | JP | 6429222 B2 | 28-11-2018 |
| | | | JP | 2018506954 A | 08-03-2018 |
| | | | US | 2018138901 A1 | 17-05-2018 |
| | | | WO | 2016204305 A1 | 22-12-2016 |
| US 2015028383 | A1 | 29-01-2015 | CN | 104347713 A | 11-02-2015 |
| | | | DE | 102014110366 A1 | 29-01-2015 |
| | | | US | 2015028383 A1 | 29-01-2015 |
| | | | US | 2015228744 A1 | 13-08-2015 |
| US 9484908 | B1 | 01-11-2016 | CN | 107820680 A | 20-03-2018 |
| | | | EP | 3311487 A1 | 25-04-2018 |
| | | | US | 9484908 B1 | 01-11-2016 |
| | | | WO | 2016204894 A1 | 22-12-2016 |

EPO FORM P0459

For more details about this annex : see Official Journal of the European Patent Office, No. 12/82